Europäisches Patentamt

(19) European Patent Office

Office européen des brevets

(11) Publication number: **0 079 181**
**B1**

(12) **EUROPEAN PATENT SPECIFICATION**

(45) Date of publication of patent specification: 26.03.86

(21) Application number: 82305761.7

(22) Date of filing: 29.10.82

(51) Int. Cl.⁴: **G 01 L 21/00, H 01 H 33/66,**
**G 01 R 31/12**

(54) **Vacuum monitor for vacuum interrupter and use of the vacuum monitor.**

(30) Priority: 30.10.81 JP 173887/81
30.10.81 JP 173890/81
29.01.82 JP 12674/82

(43) Date of publication of application:
18.05.83 Bulletin 83/20

(45) Publication of the grant of the patent:
26.03.86 Bulletin 86/13

(84) Designated Contracting States:
CH DE FR GB IT LI NL SE

(56) References cited:
US-A-3 403 297
US-A-3 882 380
US-A-4 021 702
US-A-4 159 446

Patent Abstracts of Japan Vol. 2, no. 156, 26
December 1978 Page 10190E78
Patent Abstracts of Japan Vol. 4, No.5, 16
January 1980 Page 157E165

(73) Proprietor: Kabushiki Kaisha Meidensha
1-17, Ohsaki 2-chome
Shinagawa-ku Tokyo 141 (JP)

(72) Inventor: Tanigaki, Shozo
29-7, Nishi-Asakusa 3-chome
Taito-ku Tokyo (JP)
Inventor: Yasuda, Tomio
20-13, Chuoh 3-chome
Kasukabe-shi Saitama-ken (JP)
Inventor: Sakaki, Masayuki
1-18, Kanda-cho
Numazu-shi Shizuoka-ken (JP)

(74) Representative: Nettleton, John Victor et al
Abel & Imray Northumberland House 303-306
High Holborn
London, WC1V 7LH (GB)

# Description

The present invention relates generally to a vacuum monitor for detecting poor vacuum pressure within a vacuum interrupter, and more specifically to a vacuum monitor which can produce an alarm or warning indication when vacuum pressure within a vacuum interrupter is abnormally increasing. The term "increasing" is used here in the sense of the vacuum becoming more imperfect.

Generally, a vacuum interrupter for use with an electric power circuit has a normal circuit interruption performance when pressure of vacuum with in its evacuated envelope is kept below 13.33 mPa ($10^{-4}$ Torr). However, the pressure of vacuum sometimes increases and the circuit interruption performance deteriorates, because of, for instance, outgassing from materials used for the interrupter or slow leakage of air (air may leak through cracks caused by undue mechanical stresses or through welded or insufficiently brazed junction portions). In case vacuum pressure increases abnormally within the evacuated envelope, the small contact spacing will no longer be able to sustain a high voltage applied to the contacts; arcs and flashovers will occur; white hot arc will burn the contact surfaces and may melt the vacuum envelope and other parts of the vacuum interrupter.

Therefore, in an electric power circuit, it is very important to check or monitor vacuum pressure within the vacuum interrupter while a vacuum interrupter is in operation; namely, even while the contacts are kept closed or opened. In recent years, accordingly, various kinds of vacuum pressure measuring devices for vacuum interrupters have been put into practical use. These vacuum pressure measuring devices, however, have the following disadvantages in practical use: (1) There exists a vacuum pressure measuring device such that a pair of electric discharge electrodes are additionally provided within the evacuated envelope and a high voltage is independently applied to the electric discharge electrodes from a separate high-voltage power supply, in order to check the change in electric discharge phenomenon caused in accordance with Paschen's law (because vacuum pressure exerts an influence upon the phenomenon of electric discharge). In such a device, the structure of the vacuum interrupter is complicated and the manufacturing cost is relatively high, because an additional high-voltage power supply is necessary. (2) There exists another vacuum pressure measuring method such that a vacuum interrupter is once disconnected from a power circuit and the movable and fixed contacts are readjusted to such an appropriate spacing that electric discharge is readily generated in accordance with Paschen's law, before applying a high voltage thereto from a separate high voltage power supply, in order to check the state of electric discharge. In such a method, the power circuit or the power supply must be disconnected from the vacuum interrupter; that is, it is impossible to check the vacuum pressure while applying a high voltage to the interrupter (i.e. under hot-line condition) and therefore it takes much time and troublesome labor.

US—A—4 021 702 discloses an arrangement in which infrared radiation emanating from a connecting post of a vacuum switching vessel is detected by a detector and converted into an electrical signal fed through an amplifier to a protective device. The detector constitutes means for receiving the radiation and evaluating the same for thereby, in turn, providing a signal indicative of a deficient operation of the vacuum switching vessel.

US—A—3 403 297 discloses a vacuum-type circuit interrupter with pressure-monitoring means. The pressure-monitoring means comprises means for applying a high potential across the evacuated space between a shield surrounding the contacts of the interrupter and the contacts when the interrupter is closed. Current-responsive alarm or protective means is provided in circuit with the high potential-applying means for operating in response to the initiation of a discharge across the said space.

With these problems in mind, therefore, it is a primary object of the present invention to provide a vacuum monitor for a vacuum interrupter which can easily check poor vacuum pressure within a vacuum interrupter, without need of any additional electric discharge electrodes or high voltage power supply, under the condition that a high supply voltage is being applied to a power circuit via a vacuum interrupter, at relatively low manufacturing cost and through simple checking procedure.

The invention as claimed provides a vacuum monitor for a vacuum interrupter, the interrupter including a fixed and a movable rod, to which rods a fixed and a movable contact are respectively joined, and also including a main shield within a tubular insulating housing, said vacuum monitor comprising a detection section for indicating when a vacuum pressure within the vacuum interrupter is above a predetermined level, characterized in that the monitor comprises an antenna disposed, in use, near conductive material of the vacuum interrupter, said antenna being designed for receiving, when an alternating voltage of a commercial frequency is applied across the rods, electromagnetic wave signals composed of any superimposed electromagnetic signals including higher frequency components of 2 KHz or more, and in that said detection section is connected to said antenna for electrically processing the electromagnetic wave signals received by said antenna, said detection section comprising a band-pass filter passing, in use, only the frequency components of the electromagnetic wave signals of 2 to 20 KHz which are generated by an electric discharge when the vacuum pressure increases within the vacuum interrupter above the predetermined level.

The antenna disposed near conductive material of the vacuum interrupter receives electromagnetic wave signals generated by electric discharge caused in accordance with a prebreakdown voltage depending upon Paschen's law when vacuum pressure increases within the vacuum interrupter and the detection section connected to the antenna for electrically processes the electromagnetic wave signals received by the antenna in order to indicate poor vacuum pressure within a vacuum interrupter.

When the fixed and movable contacts are kept open, the above-mentioned electric discharge is mainly generated between the two contacts; however, when the two contacts are kept closed, the above-mentioned electric discharge is generated between the fixed and movable contact rods including the two contacts and the main shield. In both the cases, it should be noted that the electric discharge caused in accordance with a prebreakdown voltage depending upon Paschen's law is quite different from so-called partial discharge (i.e. corona discharge).

The invention, as set out in claim 2, refers also to the use of the vacuum monitor.

Ways of carrying out the invention are described in detail below with reference to drawings which illustrate several specific embodiments.

In the accompanying drawings like reference numerals designate the same or similar elements or sections throughout the figures thereof and:

Fig. 1 is a longitudinal cross-sectional view of a vacuum interrupter provided with a first embodiment of the vacuum monitor according to the present invention, in which the fixed and movable contacts are kept opened;

Fig. 2(A) is an equivalent circuit diagram of the vacuum interrupter shown in Fig. 1, in which the two contacts thereof are kept opened;

Fig. 2(B) is an equivalent circuit diagram of the vacuum interrupter shown in Fig. 1, in which the two contacts thereof are kept closed;

Fig. 3 is a schematic block diagram of the vacuum monitor for a vacuum interrupter according to the present invention shown in Fig. 1;

Fig. 4(A) is a graphical representation showing a 50 Hz voltage wave-form developing across the fixed and movable contacts of a vacuum interrupter, when the vacuum pressure within the interrupter is normal;

Fig. 4(B) is a graphical representation showing a 50 Hz voltage wave-form received by an antenna attached to the vacuum monitor according to the present invention, when the vacuum pressure within the interrupter is normal;

Fig. 5(A) is a graphical representation showing a 50 Hz voltage wave-form developing across the fixed and movable contacts of a vacuum interrupter, when the vacuum pressure within the interrupter is abnormal;

Fig. 5(B) is a graphical representation showing a 50 Hz voltage wave-form received by an antenna attached to the vacuum monitor according to the present invention, when the vacuum pressure within the interrupter is abnormal;

Fig. 6 is a longitudinal cross-sectional view of a vacuum interrupter provided with a second embodiment of the vacuum monitor according to the present invention, in which the fixed and movable contacts are kept closed;

Fig. 7 is a longitudinal cross-sectional view of a first vacuum circuit breaker including a vacuum interrupter and an operating apparatus (not shown) therewithin and the vacuum monitor according to the present invention;

Fig. 8 is a pictorial view of a second vacuum circuit breaker including a vacuum interrupter therewithin and the vacuum monitor according to the present invention;

Fig. 9 is a pictorial view of a first vacuum switch gear including a vacuum interrupter therewithin and the vacuum monitor according to the present invention; and

Fig. 10 is a pictorial view of a second vacuum switch gear including a vacuum interrupter therewithin and the vacuum monitor according to the present invention.

In view of the above description, reference is now made to a first embodiment of the vacuum monitor for a vacuum interrupter according to the present invention.

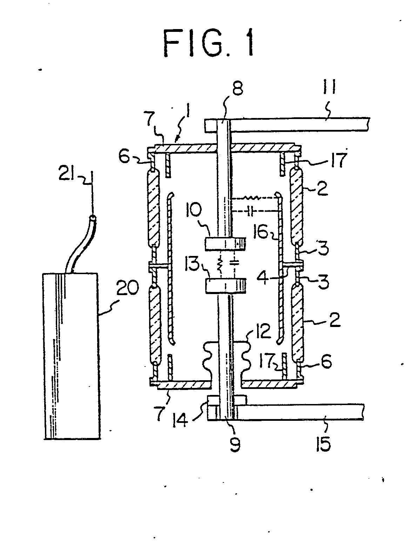

In Fig. 1, the reference numeral 1 denotes a typical vacuum interrupter, the evacuated envelope of which comprises two tubular insulating housings 2 made of glass or ceramics and hermetically joined to each other by two metallic tubes 3 with a disk 4 sandwiched therebetween, and a pair of metallic end caps 7 also hermetically joined to the tubular insulating housing 2, respectively, with a metallic tube 6 joined hermetically on either opposite side (upper and lower sides) of the insulating housing 2. At the center of the respective end caps 7, there are disposed two conductive contact rods 8 and 9. The fixed conductive contact rod 8 is hermetically joined at its upper end to the upper metallic end cap 7. A fixed contact 10 is fixedly brazed to the lower end of the fixed conductive contact rod 8 and an external connection conductor 11 is joined to the upper end of the fixed conductive contact rod 8. The movable conductive contact rod 9 is movably joined to the lower end cap 7 through a metal bellows 12 so as to be freely movable in the axial direction of the envelope without destroying a vacuum within the envelope. A movable contact 13 is fixedly brazed to the upper end of the movable conductive contact rod 9, and a slide contact 14 is slidably fitted to the lower end of the movable contact rod 9. Further, the numeral 15 denotes another external connection conductor for mounting the slide contact 14. Therefore, even when the movable contact rod 9 moves up and down (an operating apparatus is not shown), the rod 9 is electrically connected to the external connection conductor 15 via the slide contact 14. The numeral 16 denotes a tubular main shield disposed at the intermediate portion of the envelope for preventing metal vapor, generated from the fixed and movable contacts 10 and 13 when they are opened or closed, from depositing onto the inner surfaces of the tubular insulating housings 2. The numeral 17 denotes a pair of upper and lower auxiliary shields. Further, in Fig. 1, when a high supply voltage is connected to the external conductor 11, a power circuit is connected to the other external conductor 15.

The vacuum interrupter 1 is operated by driving the movable contact 13 up and down to close and open an electric power circuit connected thereto. When the two contacts are closed, current flows from the upper external connection conductor 11 to the lower external connection conductor 15 or vice versa, through the path of the fixed contact rod 8, the fixed contact 10, the movable contact 13 and the movable contact rod 9.

Power circuit interruption is effected by driving the movable contact 13 downward so as to be separated from the fixed contact 10 by an appropriate operating apparatus (not shown).

Further, in Fig. 1, a vacuum monitor 20 having an antenna 21 according to the present invention (explained in more detail later) is disposed near the vacuum interrupter 1 for detecting poor vacuum pressure within the interrupter envelope.

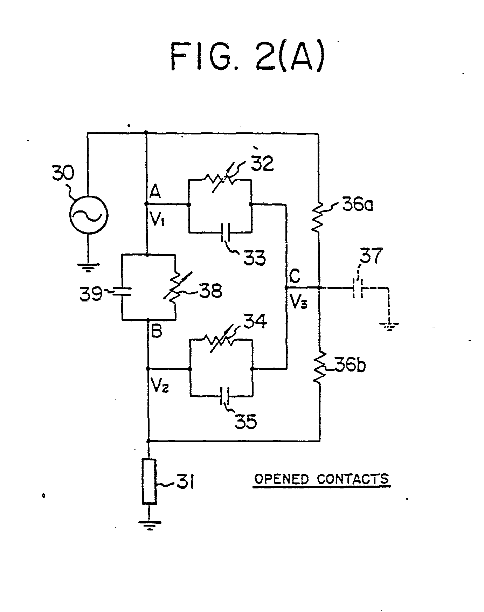

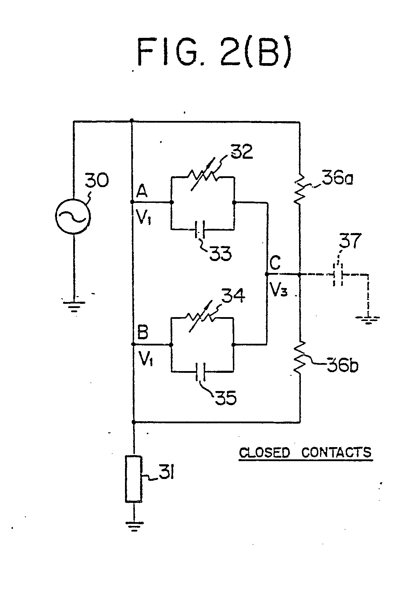

Fig. 2(A) is an equivalent circuit diagram of the vacuum interrupter shown in Fig. 1, in which the two contacts thereof are kept opened. Fig. 2(B) is the same circuit diagram, in which the two contacts thereof are kept closed. In the figures, the reference numeral 30 denotes a power supply for a power circuit to be interrupted by a vacuum interrupter; the reference numeral 31 denotes a load for the power circuit. The reference numeral 32 denotes an insulation resistance existing between the fixed contact 10 including the fixed contact rod 8 and the main shield 16; the numeral 33 denotes a stray capacitance existing between the fixed contact 10 including the fixed contact rod 8 and the main shield 16. The reference numeral 34 denotes an insulation resistance existing between the movable contact 13 including the movable contact rod 9 and the main shield 16; the numeral 35 denotes a stray capacitance existing between the movable contact 13 including the movable contact rod 9 and the main shield 16. The reference numerals 36a and 36b denote insulation resistances in the two tubular insulating housings 2, respectively; the numeral 37 denotes a stray capacitance existing between the main shield 16 and the ground. Further, in Fig. 2(A), the reference numeral 38 denotes an insulation resistance existing between the fixed and movable contacts 10 and 13, and the numeral 39 denotes a stray capacitance existing between the two contacts 10 and 13, in the case where the two contacts are opened.

In Figs. 2(A) and 2(B), only the insulation resistances are represented in the form of variable resistor. The reason is as follows: since the dielectric constant in a vacuum is almost the same as that in the air, the stray capacitances 33, 35, 37, and 39 do not change even when the vacuum pressure within the vacuum interrupter deteriorates, that is, increases. On the other hand, the insulation resistances 32, 34, and 38 change in accordance with a prebreakdown voltage depending upon Paschen's law when the vacuum pressure deteriorates. Generally, Paschen's law indicates that breakdown voltage in a vacuum decreases with increasing products of vacuum pressure Pa (Torr) and contact gap distance (mm) to a certain point of inflection and then increases with the increasing products after exceeding the inflection point.

In the figure, assuming that the potential is $V_1$ at junction point A, the potential is $V_2$ at junction point B, and the potential (floating potential) is $V_3$ at junction point C, the potential differences $(V_1 - V_2)$, $(V_1 - V_3)$ and $(V_2 - V_3)$ between A and B, A and C, and B and C change according to the values of the variable resistors, 38, 32, and 34, respectively; that is, the vacuum pressure within the envelope shown in Fig. 1. In more detail, when the vacuum pressure within the interrupter is normal lying less than 13.33 mPa ($10^{-4}$ Torr), the respective potential differences are constant; however, in case the vacuum pressure becomes poor or increases gradually due to air leakage or outgassing and therefore ions are produced within the envelope, the insulation resistances 32, 34 and 38 decrease, thus resulting in strange electric dark current flowing mainly between the fixed and movable contacts 10 and 13 when the two contacts are kept open, and between the fixed and movable contact rods 8 and 9 including the two contacts and the main shield 16 when the two contacts are kept closed.

The insulation resistance 38, 32 or 34 drops gradually over a long time (e.g. 2 to 3 years) and therefor strange electric dark current will flow therebetween, thus a kind of strange electromagnetic wave being emitted. Since the electromagnetic wave generated by the above-mentioned potential difference (between A and B or between A and C or B and C) tends to be propagated in conductive material connected to the vacuum interrupter and to be emitted therefrom, it is possible to indirectly check poor vacuum pressure within a vacuum interrupter by placing an antenna near a conductive material of the interrupter in order to detect the electromagnetic wave signals generated by strange electric dark discharge when the vacuum pressure increases within the vacuum interrupter.

Further, in the above description, it is obvious that the potential $V_1$ is equal to the potential $V_2$ when the two contacts are kept closed and the floating potential $V_3$ changes according to the stray capacitance 37 which is usually determined by the grounded condition.

It should be noted that the above-mentioned electric discharge is quite different from so-called partial discharge or corona discharge which is caused by uneven electric field and results in local insulation destruction.

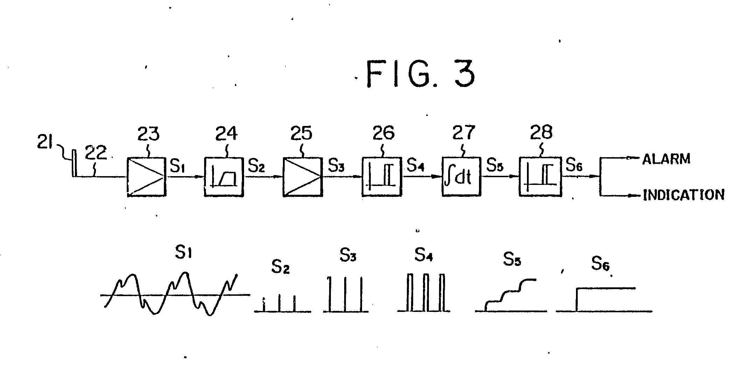

Fig. 3 shows a schematic block diagram of the vacuum monitor 20 according to the present invention shown in Fig. 1. The vacuum monitor 20 comprises an antenna 21 and an antenna cable 22, and a detection section 20 including a buffer amplifier 23, a band-pass filter 24, an amplifier 25, a first comparator 26, an integrator or a counter 27 and a second comparator 28. The antenna 21 detects the electromagnetic wave signals existing near a conductive material of a vacuum interrupter. The buffer amplifier 23 having a high input impedance amplifies the signal received by the antenna 21 and outputs the signal $S_1$ as shown in Fig. 3. The signal $S_1$ indicates that the electromagnetic wave signals are superimposed as ripples upon a commercial frequency of, for instance, 50 or 60 Hz. The band-pass filter 24 passes only the frequency components of 2 to 20 kHz from the signal $S_1$ (the commercial frequency components are, of course eliminated) and outputs signal $S_2$. That is to say, this band-pass filter 24 serves to eliminate frequency components of less than 2 kHz from the signal $S_1$. This is because rotary machines, transformers, power measurement instruments, etc. often generate signals including higher harmonics of 2 kHz or less. The amplifier 25 amplifies the filtered signal $S_2$ to the corresponding signal $S_3$. The first comparator 26 compares this amplified signal $S_3$ with a predetermined reference voltage level and outputs a signal $S_4$ whenever the amplified signal $S_3$ exceeds the reference level. The integrator (or a counter) 27 continually integrates or counts the number of the signal $S_4$ and outputs the corresponding signal $S_5$. The second comparator 28 compares the integrated or counted signal $S_5$ with another predetermined reference value and outputs a signal $S_6$ when the signal $S_5$ exceeds the reference level. This signal $S_6$ outputted from the second comparator 28 is used for producing an alarm or for activating an indicator to show poor vacuum pressure or that vacuum pressure is abnormally increasing within the interrupter.

The above-mentioned vacuum monitor 20 can be used by fixedly installing it (as a fixed-type vacuum monitor or by movably approaching it (as a portable-type vacuum monitor) near a vacuum interrupter. In both the cases, in particular, in a portable type one, since it is very dangerous that all the monitor elements are connected electrically (because a high-voltage electric shock will be applied to the human body in case the antenna is brought into contact with the external connection conductor), generally the buffer amplifier 23 is disconnected electrically from the bandpass filter 24 and is connected optically by using an appropriate optical signal transmitting means such as a light emitting diode, a phototransistor, optical fibers, etc.

Further, when used as a portable-type vacuum monitor, the antenna portion is electrically separated from the detection section by an insulating rod. In more detail, on top of the insulating rod there are mounted the antenna and an E—O (electrooptical) converter, and received electromagnetic wave signals are inputted through optical fiber to the detection section mounted on the bottom side of the rod in order to prevent electric shock. Further, in monitoring vacuum pressure, only the antenna portion is brought near the vacuum interrupter to be monitored.

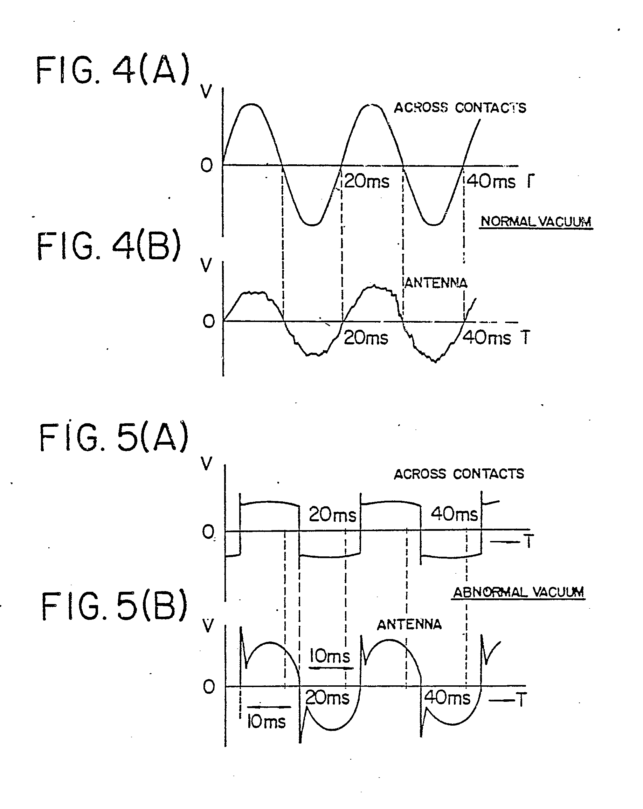

Now, follows a description of the wave-forms of the electromagnetic wave signals received by the antenna attached to the vacuum monitor according to the present invention, with reference to Figs. 4 and 5.

Fig. 4(A) shows the wave-form of the voltage signal developing across the two contacts when the vacuum pressure within the vacuum interrupter is normal (e.g. 13.33 mPa ($10^{-4}$ Torr) or less). Fig. 4(B) shows the wave-form of the signal received by the antenna when the vacuum pressure is normal. These figures indicate that under normal vacuum pressure the voltage wave-form across the two contacts is a sine wave of a commercial frequency (e.g. 50 or 60 Hz) and the signal received by the antenna is roughly a sine wave upon which signals including higher harmonics of 2 kHz or less are superimposed. These superimposed signals may be generated for rotary machines, transformers, measuring devices, etc. installed near the vacuum interrupter or in or near the electric power circuit to which the vacuum interrupter is connected. As already described, since a band-pass filter 24 is provided for the vacuum monitor, these signals with frequencies of 2 kHz or less can be eliminated. Further, by connecting a certain capacitor to the input terminal of the buffer amplifier 23, commercial frequency components of 50 or 60 Hz can easily be eliminated. That is to say, when the vacuum pressure within the vacuum interrupter is normal, the vacuum monitor outputs no signal.

On the other hand, Fig. 5(A) shows the wave-form of the voltage signal developing across the two contacts when the vacuum pressure is abnormal (e.g. 133.3 mPa ($10^{-3}$ Torr) or more). Fig. 5(B) shows the wave-form of the electromagnetic wave signals received by the antenna when the vacuum pressure is abnormal. These figures indicate that under abnormal vacuum pressure the voltage wave-form across the two contacts is roughly a square wave, the phase thereof being a little delayed, and the voltage wave-form of the electromagnetic wave signal received by the antenna is of a peculiar figure in which ripples including relatively-high frequency components of 2 kHz or more are superimposed upon a sine wave.

This is because once electric discharge begins within the vacuum interrupter, the voltage across the contacts cannot rise up to the peak value as shown in Fig. 4(A) being clipped at a certain voltage level. Further, whenever the voltage across the contacts rises sharply, the ripple is generated. The reason why the signal of such a wave-form as described above is received by the antenna when electric discharge begins under abnormal vacuum pressure has not yet perfectly been analyzed. However, it is true that the signal as described above can be received by the antenna whenever the vacuum pressure within the vacuum interrupter increases abnormally, and the frequency components of the electromagnetic wave signal lie between 2 and 20 kHz, which is higher than those generated from machines or devices other than the vacuum interrupter.

Therefore, by detecting the electromagnetic wave ripple signals superimposed on the sine wave, it is possible to check the generation of electric discharge within the interrupter due to poor vacuum pressure. Furthermore, even if partial discharge is generated from other devices, since the wave-form thereof is quite different from that of electromagnetic wave signal generated by the dark current discharge and the frequency components thereof are generally lower than that of the electromagnetic wave signal, there will exist no harmful influence upon the detection characteristics of the vacuum monitor.

There will be described hereinbelow the experimental results of the vacuum interrupter and the vacuum monitor according to the present invention.

In the case where the vacuum pressure within a vacuum interrupter is changed within the range of 666.5 mPa ($5 \times 10^{-3}$ Torr) to 39.99 kPa (300 Torr), the frequency components of the electromagnetic wave signals received by the antenna ranges from 10 to 14 kHz when the electrostatic capacitance between the load and the ground is 0.0042 µF, from 2 to 8 kHz when the capacitance is 0.05 µF, and from 2 to 20 kHz when the capacitance is 0.2 µF or more. Further, when the capacitance is as small as 0.0042 µF or less, since experiment has indicated that the detection sensitivity becomes unstable, the detection sensitivity can be improved by connecting a capacitance of about 0.25 µF on the load side of the vacuum interrupter, in order to stably detect the electromagnetic wave signals caused by abnormal poor vacuum pressure.

Further, in the case where a vinyl-coated copper cable antenna with a length of 30 cm and a cross-sectional area of 1.25 mm$^2$ is placed 1 m away from 6.9 kV-class vacuum interrupter, the vacuum pressure of which is approximately 13.33 Pa ($10^{-1}$ Torr, and a voltage of $6.9/\sqrt{3} \doteqdot 4$ kV is applied to the interrupter with a capacitor of 0.2 µF connected between the load-side conductor and the ground, when the two contacts are kept open, the detected signal voltage outputted from the amplifier 25 is about 0.6V if the gain thereof is 10,000.

Further, under almost the same experiment conditions, when the two contacts are kept closed, the detected signal voltage outputted from the amplifier 25 is about 0.3V.

The reason why the detected signal voltage is low when the two contacts are closed, in comparison with that obtained when the two contacts are opened, may be due to the following fact: when the two contacts are closed, since electric discharge is generated only between the fixed and movable contact rods 8 and 9 including the fixed and movable contacts 10 and 13 and the main shield 16, the insulation resistance (parallel connection of 32 and 34) existing therebetween may be greater than the insulation resistance 38 existing between two contacts, and therefore the electric discharge energy obtained when the two contacts are closed may be smaller than that obtained when the two contacts are opened.

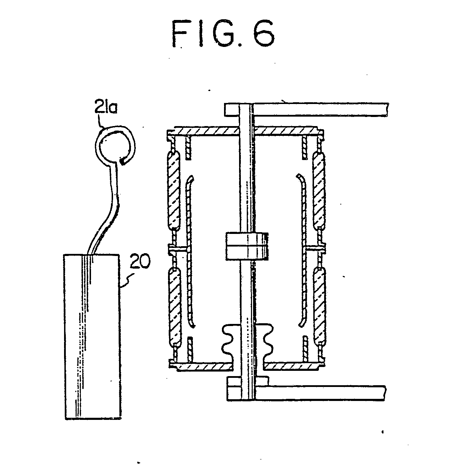

Fig. 6 shows a second embodiment of the vacuum monitor according to the present invention. In this embodiment a loop antenna 21a is provided for the vacuum monitor in place of a rod antenna 21 shown in Fig. 1. The equivalent length of this loop antenna 21a is almost the same as that of the rod antenna 21. That is to say, the diameter of this loop antenna is about 10 cm and the straight portion thereof is about 5 cm. When the loop antenna having the above-mentioned dimensions is placed near a vacuum interrupter under the same experiment conditions as already described, it is possible to detect poor vacuum pressure in the same way as already explained hereinabove. Further, Fig. 6 shows a vacuum interrupter in which the two contacts thereof are kept closed, in order to clearly illustrate that it is also possible to detect poor vacuum pressure even when the contacts are kept closed and when a high voltage is kept applied to a power circuit through a vacuum interrupter; in other words, under hot-line condition.

The description has been made hereinabove of the case where the vacuum monitor according to the present invention is disposed near a bare vacuum interrupter in order to detect vacuum pressure deterioration. However, ultra-high-voltage class vacuum interrupters (e.g. 66 kV or more) are usually used being housed within a tank filled with an insulating medium such as insulation oil or gas.

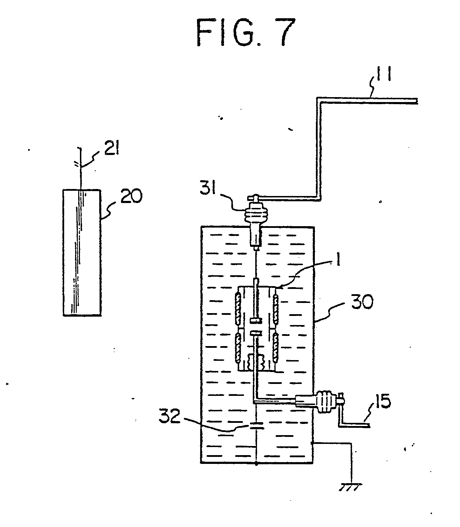

Fig. 7 shows an example of these cases. In the figure, the reference numeral 30 denotes a tank filled with an insulating medium, which is made of metal plate such as iron or stainless steel plates. The reference numeral 31 denotes a porcelain bushing through which a conductor is passed and connected to the fixed contact rod. The numerals 11 and 15 denote external connection conductors. Further, the numeral 32 denotes a capacitor connected between the movable contact side conductor and the tank in order to increase detection sensitivity when the two contacts are kept closed.

In such cases, it is preferable to place the antenna 21 of the vacuum monitor 20 near the porcelain bushing 31. This is because the vacuum interrupter is housed within a tank and the tank is grounded.

In the case where a vinyl-coated copper cable antenna with a length of 30 cm and a cross-sectional area of 1.25 mm$^2$ is placed 1 m away from the porcelain bushing of a 6.9 kV-class vacuum interrupter housed within a tank filled with an insulating oil, the vacuum pressure of which is approximately 39.99 Pa (0.3 Torr), and a voltage of 6.9/√3≑4 kV is applied to the interrupter with a capacitor of 0.25 µF connected between the load-side conductor and the tank (grounded), when the two contacts are kept open, the detected signal voltage outputted from the amplifier 25 is about 0.4V if the gain thereof is 10,000. Further, in this case, the capacitance of 0.25 µF corresponds to that obtained when a 1 km-long 6.9 kV-class cable is laid.

This capacitor 32 of 0.25 µF is effective especially when vacuum pressure is required to check in the state when the two contacts are kept closed. This is because the field strength of the electromagnetic wave signals caused by electric discharge between the two contact rods including two contacts and the main shield is relatively weak.

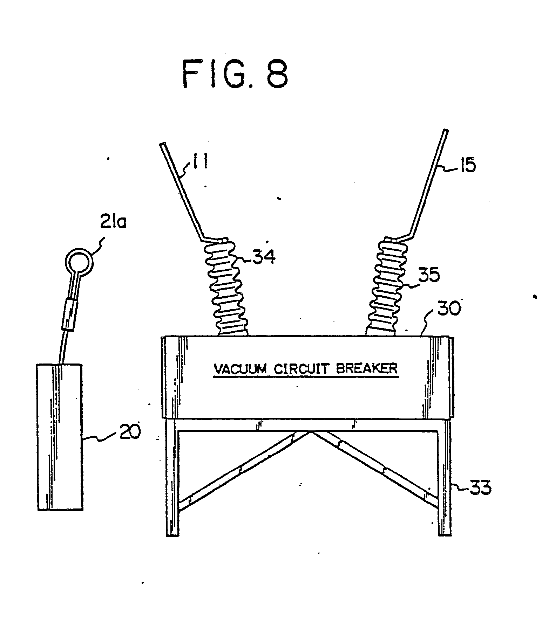

Fig. 8 shows an example of detecting poor vacuum pressure within a vacuum interrupter housed within a tank 30 together with other operating devices. The vacuum interrupter incorporated with other operating devices such as a motor is called a vacuum circuit breaker herein. In the figure, the tank 30 is mounted on a stand frame 33. The first porcelain bushing 34 is used for insulating from the tank 30 a first external connection conductor 11 to which a power supply is connected, and the second porcelain bushing 35 is used for insulating from the tank 30 a second external connection conductor 15 to which a load is connected. In this case, it is preferable to place the antenna 21 or 21a of the vacuum monitor 20 near the first porcelain bushing 34.

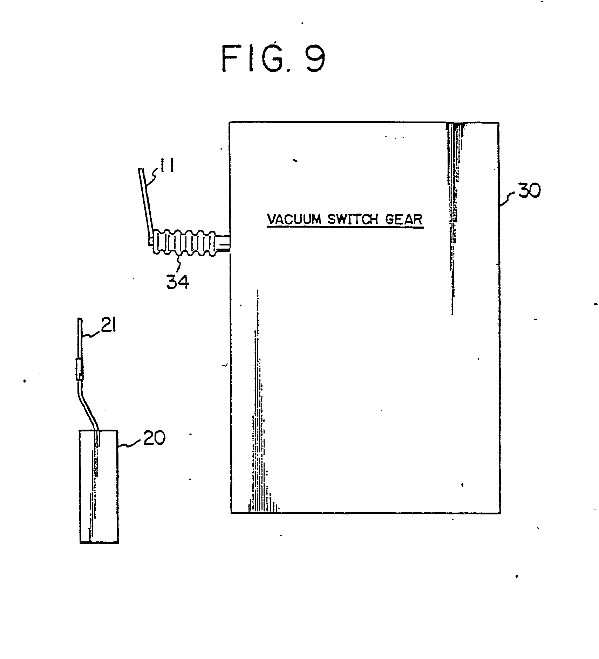

Fig. 9 shows an example of detecting poor vacuum pressure within a vacuum interrupter housed within a tank 30, that is, within a single-phase vacuum switch gear. In the figure, a porcelain bushing 34 is provided for insulating from the. tank 30 an external connection conductor 11 to which a power supply is connected. In this case, the antenna 21 or 21a of the vacuum monitor 20 is placed near the porcelain bushing 34.

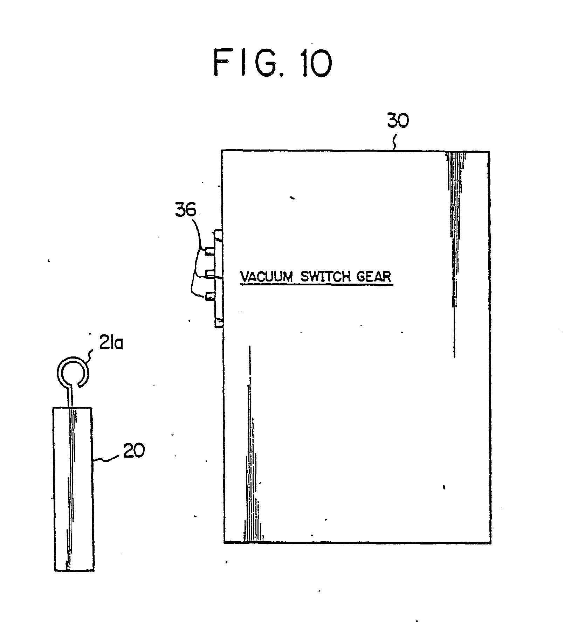

Fig. 10 shows an example of detecting poor vacuum pressure within a vacuum interrupter housed within a tank 30 of a vacuum switch gear in which various power elements or devices are housed together. In the figure, a three-phase external terminal 36 is provided for connecting external devices thereto. In this case, the antenna 21 or 21a of the vacuum monitor 20 is placed near the three-phase terminal 36 attached to the outside surface of the tank 30.

Conventionally, complicated steps have been required for checking the vacuum pressure within a vacuum interrupter housed within a tank filled with an insulating oil or gas as follows: First, the insulating oil or gas is removed from the tank; secondly, the contact gap between the fixed and the movable contacts is so adjusted as to become an appropriate spacing suitable for dielectric strength test in accordance with Paschen's law; thirdly, a high voltage is applied to the contact gap in accordance with a method of voltage-withstand test, fourthly, the contact gap of the checked vacuum interrupter is returned to its original spacing; lastly, the interrupter is placed within a tank and an insulating oil or gas is filled therewithin. Accordingly, it takes much time and labor to check the vacuum pressure and additionally there inevitably exists a difference in contact gap spacing between before and after the vacuum pressure is checked; that is, it is very difficult to return the contacts to the original gap condition. In this invention, however, since there are no needs of such complicated test procedures as described above and of providing any additional parts or elements or a separate high-voltage power supply, it is possible to check the deterioration of vacuum pressure easily. and accurately at a low cost.

The vacuum monitor according to the present invention is applicable to almost all the ordinary vacuum interrupters now in use, excluding the ones which are perfectly ground-shielded, and advantageously can check the vacuum pressure while a voltage is kept applied to the interrupter, that is, under hot-line condition. Further, since a commercial domestic power supply (100 or 200 V) or battery cells can be used as the power supply for the monitor, it is possible to realize a small-sized lightweight portable-type vacuum monitor. Furthermore, the more the contact spacing, the higher the detection sensitivity of the monitor. This is because the electric dark discharge is generated at a lower voltage in dependence upon Paschen's law. Therefore, it is possible to check vacuum pressure within such a range as wide as 133.3 mPa ($10^{-3}$ Torr) to 13.33 kPa (100 Torr).

As described above, in the vacuum monitor according to the present invention, since the vacuum pressure within a vacuum interrupter can be checked, on the basis of the electromagnetic wave signals generated by electric discharge existing between the two contacts in the case when the two contacts are kept open or between the two contact rods including the contacts and the main shield in the case when the two contacts are kept closed in accordance with a prebreakdown voltage depending upon Paschen's law, by the use of an antenna placed near the conductive material of the interrupter and since the antenna-received signal including only higher harmonics of 2 to 20 kHz is amplified and compared with a predetermined reference value to output an alarm signal, it is possible to realize a very convenient, low-priced, small-sized vacuum monitor for a vacuum interrupter.

It will be understood by those skilled in the art that the foregoing description is in terms of a preferred embodiment of the present invention wherein various changes and modifications may be made without departing from the spirit and scope of the invention, as set forth in the appended claims.

**Claims**

1. A vacuum monitor for a vacuum interrupter, the interrupter (1) including a fixed (8) and a movable (9) rod, to which rods a fixed (10) and a movable (13) contact are respectively joined, and also including a main shield (16) within a tubular insulating housing (2), said vacuum monitor (20, 21; 20, 21a) comprising a detection section (20) for indicating when a vacuum pressure within the vacuum interrupter (1) is above a predetermined level, characterized in that the monitor comprises an antenna (21; 21a) disposed, in use, near conductive material (8, 11, 9, 15, 3, 6; 36) of the vacuum interrupter, said antenna being designed for receiving, when an alternating voltage of a commercial frequency is applied across the rods, electromagnetic wave signals composed of any superimposed electromagnetic signals including higher frequency components of 2 kHz or more, and in that said detection section (20) is connected to said antenna (21; 21a) for electrically processing the electromagnetic wave signals received by said antenna, said detection section comprising a band-pass filter (24) passing, in use, only the frequency components of the electromagnetic wave signals of 2 to 20 kHz which are generated by an electric discharge when the vacuum pressure increases within the vacuum interrupter above the predetermined level.

2. Use of the vacuum monitor of claim 1 with a vacuum interrupter as set out in claim 1, wherein the fixed (10) and movable (13) contacts of the vacuum interrupter (1) are kept open, whereby the electromagnetic wave signals are generated by an electric discharge existing between said fixed and movable contacts.

3. Use of the vacuum monitor of claim 1 with a vacuum interrupter as set out in claim 1, wherein the fixed (10) and movable (13) contacts of the vacuum interrupter (1) are kept closed, whereby the electromagnetic wave signals are generated by an electric discharge existing between the fixed (8) and movable (9) rods including fixed and movable contacts and the main shield (16).

4. Use of the vacuum monitor of claim 1 with a vacuum interrupter as set out in claim 1, wherein the vacuum interrupter (1) is housed within a metal tank (30) filled with an insulating medium, and a capacitor (32) is connected between load side conductive material (15) of the vacuum interrupter and the ground to increase detection sensitivity for the electromagnetic wave signals.

5. Use of the vacuum monitor of claim 1 with the vacuum interrupter used in claim 4, wherein said conductive material (11, 15) passes through a porcelain bushing (34, 35) attached to the metal tank (30) within which a vacuum circuit breaker including the vacuum interrupter (1) is housed.

6. Use of the vacuum monitor of claim 1 with the vacuum interrupter used in claim 4, wherein said conductive material has an external portion (11, 15) comprising a three-phase external terminal (36) attached to the metal tank (30) within which switch gear including a vacuum circuit breaker with the vacuum interrupter (1) is housed.

7. Use of the vacuum monitor of claim 1 with the vacuum interrupter used in claim 4, wherein the capacitance of said capacitor (32) is approximately 0.2 µF.

8. A vacuum monitor for a vacuum interrupter as set forth in claim 1, wherein said antenna is a rod antenna (21).

9. A vacuum monitor for a vacuum interrupter as set forth in claim 1, wherein said antenna is a loop antenna (21a).

10. A vacuum monitor for a vacuum interrupter as set forth in claim 1, wherein said detection section (20) further comprises:

(a) a first comparator (26) connected to said band-pass filter (24) for comparing a voltage level at the output of the band-pass filter with a predetermined reference voltage level and for outputting signals when the voltage level at the output of the band-pass filter exceeds the predetermined reference level;

(b) a counter (27) connected to said first comparator for counting the number of signals at the counter output exceeding the predetermined reference level; and

(c) a second comparator (28) connected to said counter (27) for comparing the number counted by said counter with a predetermined reference number and outputting a signal when the counted number exceeds the predetermined reference number to indicate that the vacuum pressure within the vacuum interrupter (1) is above the predetermined reference level.

11. A vacuum monitor for a vacuum interrupter as set forth in claim 1, wherein, in use, said antenna (21; 21a) is fixedly disposed near the conductive material (8, 11, 9, 15, 3, 6; 36).

12. A vacuum monitor for a vacuum interrupter as set forth in claim 1, wherein, in use, said antenna (21; 21a) is movably disposed near the conductive material (8, 11, 9, 15, 3, 6; 36).

**Patentansprüche**

1. Vakuum-Überwachungsgerät für einen Vakuum-Schalter, wobei der Schalter (1) einen feststehenden (8) und einen bewegbaren (9) Stab enthält, mit welchen Stäben ein feststehender (10) bzw. ein bewegbarer (13) Kontakt verbunden ist, und auch einen Hauptschirm (16) in einem rohrförmigen isolierenden Gehäuse (2) enthält, wobei das Vakuum-Überwachungsgerät (20, 21; 20, 21a) einen Erfassungsabschnitt (20) umfaßt zur Anzeige, wenn ein Vakuumwert innerhalb des Vakuum-Schalters (1) sich über einem vorbestimmten Pegel befindet, dadurch gekennzeichnet, daß das Überwachungsgerät eine im Gebrauch in der Nähe von leitfähigem Material (8, 11, 9, 15, 3, 6; 36) des Vakuum-Schalters angeordnete Antenne (21; 21a) enthält, welche dazu ausgelegt ist, wenn eine alternierende Spannung einer üblichen Frequenz über die Stäbe angelegt ist, elektromagnetische Wellensignale zu empfangen, die aus irgendwelchen überlagerten elektromagnetischen Signalen einschließlich höherer Frequenz-Komponenten von 2 kHz oder mehr zusammengesetzt sind, und daß der Erfassungsabschnitt (20) an der Antenne (21; 21a) angeschlossen ist zur elektrischen Verarbeitung der durch die Antenne empfangenen elektromagnetischen Wellensignale, wobei der Erfassungsabschnitt einen Bandpaßfilter (24) umfaßt, der im Gebrauch nur die Frequenzkomponenten der elektromagnetischen Wellensignale mit 2 bis 20 kHz durchläßt, ·die durch eine elektrische Entladung erzeugt werden, wenn der Vakuumwert in dem Vakuum-Schalter über den vorbestimmten Pegel ansteigt.

2. Verwendung des Vakuum-Überwachungsgerätes nach Anspruch 1 mit einem Vakuum-Schalter, wie in Anspruch 1 angeführt, wobei der feststehende (10) und der bewegbare (13) Kontakt des Vakuum-Schalters (1) offengehalten sind, wodurch die elektromagnetischen Wellensignale durch eine zwischen dem feststehenden und dem bewegbaren Kontakt bestehende elektrische Entladung erzeugt werden.

3. Verwendung des Vakuum-Überwachungsgerätes nach Anspruch 1 mit einem Vakuum-Schalter, wie in Anspruch 1 angeführt, wobei der feststehende (10) und der bewegbare (13) Kontakt des Vakuum-Schalters (1) geschlossen gehalten sind, wodurch die elektromagnetischen Wellensignale durch eine zwischen dem feststehenden (8) und dem bewegbaren (9) Stab einschließlich der festen und bewegbaren Kontakte und dem Hauptschirm (16) bestehende elektrische Entladung erzeugt werden.

4. Verwendung des Vakuum-Überwachungsgerätes nach Anspruch .1 mit einem Vakuum-Schalter, wie in Anspruch 1 angeführt, wobei der Vakuum-Schalter (1) in einem mit einem isolierenden Medium angefüllten Metalltank (30) aufgenommen ist, und ein Kondensator (32) zwischen dem lastseitigen leitfähigen Material (15) des Vakuum-Schalters und Erde angeschlossen ist, um die Erfassungs-Empfindlichkeit für die elektromagnetischen Wellensignale zu erhöhen.

5. Verwendung des Vakuum-Überwachungsgerätes nach Anspruch 1 mit dem in Anspruch 4, verwendeten Vakuum-Schalter, wobei das leitfähige Material (11, 15) durch eine Porzellandurchführung (34, 35) hindurchtritt, welche an dem Metalltank (30) angebracht ist, innerhalb dessen ein den Vakuum-Schalter (1) enthaltender Vakuum-Leitungstrenner untergebracht ist.

6. Verwendung des Vakuum-Überwachungsgerätes nach Anspruch 1 mit dem in Anspruch 4 verwendeten Vakuum-Schalter, wobei das leitfähige Material einen äußeren Abschnitt (11, 15) besitzt mit einer äußeren Dreiphasenklemme (36), die an dem Metalltank (30) angebracht ist, innerhalb dessen einen Vakuum-Leitungstrenner mit dem Vakuum-Schalter (1) enthaltendes Schaltgetriebe untergebracht ist.

7. Verwendung des Vakuum-Überwachungsgerätes nach Anspruch 1 mit dem in Anspruch 4 verwendeten Vakuum-Schalter, wobei die Kapazität des Kondensators (32) annähernd 0,2 µF beträgt.

8. Vakuum-Überwachungsgerät für einen Vakuum-Schalter nach Anspruch 1, wobei die Antenne eine Stabantenne (21) ist.

9. Vakuum-Überwachungsgerät für einen Vakuum-Schalter nach Anspruch 1, wobei die Antenne eine Schleifenantenne (21a) ist.

10. Vakuum-Überwachungsgerät für einen Vakuum-Schalter nach Anspruch 1, wobei der Überwachungsabschnitt (20) weiter umfaßt:

a) einen ersten an dem Bandpaßfilter (24) angeschlossenen Komparator (26) zum Vergleich eines Spannungspegels am Ausgang des Bandpaßfilters mit einem vorbestimmten Referenzspannungspegel und zum Ausgeben von Signalen, wenn der Spannungspegel am Ausgang des Bandpaßfilters den vorbestimmten Referenzpegel überschreitet;

b) einen an dem ersten Komparator angeschlossenen Zähler (27) zum Zählen der Anzahl der Signale am Komparatorausgang bei Überschreiten des vorbestimmten Referenzpegels; und

c) einen an dem Zähler (27) angeschlossenen zweiten Komparator (28) zum Vergleichen der durch den Zähler gezählten Zahl mit einer vorbestimmten Referenzzahl und zum Ausgeben eines Signales, wenn die gezählte Zahl die vorbestimmte Referenzzahl überschreitet, um anzuzeigen, daß der Vakuumwert innerhalb des Vakuum-Schalters (1) sich über dem vorbestimmten Referenzpegel befindet.

11. Vakuum-Überwachungsgerät für einen Vakuum-Schalter nach Anspruch 1, bei dem im Gebrauch die Antenne (21; 21a) fest in der Nähe des leitfähigen Materials (8, 11, 9, 15, 3, 6; 36) angeordnet ist.

12. Vakuum-Überwachungsgerät für einen Vakuum-Schalter nach Anspruch 1, wobei im Gebrauch die Antenne (21; 21a) bewegbar in der Nähe des leitfähigen Materials (8, 11, 9, 15, 3, 6; 36) angeordnet ist.

**Revendications**

1. Dispositif de contrôle de vide destiné à un interrupteur sous vide, l'interrupteur (11) comprenant une tige fixe (8) et une tige mobile (9), un contact fixe (10) et un contact mobile (13) étant fixés respectivement aux tiges, et comprenant aussi un blindage principal (16) placé dans un boîtier tubulaire isolant (2), le dispositif de contrôle de vide (20, 21; 20, 21a) comprenant une section de détection (20) destinée à indiquer lorsque la pression dans l'interrupteur sous vide (1) dépasse un niveau prédéterminé, caractérisé en ce que le dispositif de contrôle comporte une antenne (21; 21a) qui, lors de l'utilisation, est placée près du matériau conducteur (8, 11, 9, 15, 3, 6; 36) de l'interrupteur sous vide, l'antenne étant destinée à recevoir, lorsqu'une tension alternative de fréquence industrielle est appliquée entre les tiges, des signaux sous forme d'ondes électromagnétiques composées de signaux électromagnétiques superposés comprenant des composantes à des fréquences élevées supérieures ou égales à 2 kHz, et en ce que la section de détection (20) est raccordée à l'antenne (21; 21a) afin qu'elle traite électriquement les signaux sous forme d'ondes électromagnétiques reçues par l'antenne, la section de détection comprenant un filtré passe-bande (24) qui, lors de l'utilisation, ne transmet que les composantes des signaux sous forme d'ondes électromagnétiques comprises entre 2 et 20 kHz, créées par une décharge électrique lorsque la pression augmente dans l'interrupteur sous vide au-delà du niveau prédéterminé.

2. Application du dispositif de contrôle de vide selon la revendication 1 avec un interrupteur sous vide tel qu'indiqué dans la revendication 1, dans laquelle les contacts fixe (10) et mobile (13) de l'interrupteur sous vide (1) sont maintenus ouverts, si bien que les signaux sous forme d'ondes électromagnétiques sont créés par une décharge électrique existant entre les contacts fixe et mobile.

3. Application du dispositif de contrôle de vide selon la revendication 1 avec un interrupteur sous vide tel que défini dans la revendication 1, dans laquelle les contacts fixe (10) et mobile (13) de l'interrupteur sous vide (1) sont maintenus fermés, si bien que les signaux sous forme d'ondes électromagnétiques sont créés par une décharge électrique existant entre les tiges fixe (8) et mobile (9) comprenant les contacts fixe et mobile et le blindage principal (16).

4. Application du dispositif de contrôle de vide selon la revendication 1 avec un interrupteur sous vide tel que défini dans la revendication 1, dans laquelle l'interrupteur sous vide (1) est logé dans un réservoir métallique (30) rempli d'un fluide isolant, et un condensateur (32) est monté entre le matériau conducteur du côté de la charge (15) de l'interrupteur sous vide et la masse afin que la sensibilité de détection des signaux sous forme d'ondes électromagnétiques soit accrue.

5. Application du dispositif de contrôle de vide selon la revendication 1 avec l'interrupteur sous vide utilisé dans la revendication 4, dans laquelle le matériau conducteur (11, 15) passe dans un manchon de porcelaine (34, 35) fixé au réservoir métallique (30) dans lequel est logé un disjoncteur sous vide comprenant l'interrupteur sous vide (1).

6. Application du dispositif de contrôle de vide de la revendication 1 avec l'interrupteur sous vide utilisé dans la revendication 4, dans laquelle le matériau conducteur a une partie externe (11, 15) comprenant une borne externe triphasée (36) fixée au réservoir métallique (30) dans lequel est logé un ensemble de commutation comprenant un disjoncteur sous vide ayant l'interrupteur sous vide (1).

7. Application du dispositif de contrôle de vide selon la revendication 1 avec un interrupteur sous vide utilisé dans la revendication 4, dans laquelle la capacité du condensateur (32) est d'environ 0,2 µF.

8. Dispositif de contrôle de vide destiné à un interrupteur sous vide selon la revendication 1, dans lequel l'antenne est une antenne sous forme d'une tige (21).

9. Dispositif de contrôle de vide destiné à un interrupteur sous vide selon la revendication 1, dans lequel l'antenne est une antenne sous forme d'une boucle (21a).

10. Dispositif de contrôle de vide destiné à un interrupteur sous vide selon la revendication 1, dans lequel la section de détection (20) comporte en outre:

(a) un premier comparateur (26) connecté au filtre passe-bande (24) et destiné à comparer un niveau de tension à la sortie du filtre passe-bande à un niveau prédéterminé de tension de référence et à transmettre des signaux lorsque le niveau de tension à la sortie du filtre passe-bande dépasse le niveau prédéterminé de référence,

(b) un compteur (27) connecté au premier comparateur et destiné à compter le nombre de signaux à la sortie du compteur au-delà du niveau prédéterminé de référence, et

(c) un second comparateur (28) connecté au compteur (27) et destiné à comparer le nombre compté par le compteur à un nombre prédéterminé de référence et à transmettre un signal lorsque le nombre compté dépasse le nombre prédéterminé de référence afin qu'il indique que la pression dans l'interrupteur sous vide (1) est supérieure au niveau prédéterminé de référence.

11. Dispositif de contrôle de vide destiné à un interrupteur sous vide selon la revendication 1, dans lequel, pendant l'utilisation, l'antenne (21; 21a) est disposée à demeure près du matériau conducteur (8, 11, 9, 15, 3, 6; 36).

12. Dispositif de contrôle de vide destiné à une interrupteur sous vide selon la revendication 1, dans lequel, pendant l'utilisation, l'antenne (21; 21a) est disposée afin qu'elle soit mobile près du matériau conducteur (8, 11, 9, 15, 3, 6; 36).

# FIG. 1

# FIG. 2(A)

OPENED CONTACTS

# FIG. 2(B)

CLOSED CONTACTS

# FIG. 3

FIG. 4(A)

ACROSS CONTACTS

20ms 40ms T

NORMAL VACUUM

FIG. 4(B)

ANTENNA

20ms 40ms T

FIG. 5(A)

ACROSS CONTACTS

20ms 40ms T

ABNORMAL VACUUM

FIG. 5(B)

ANTENNA

10ms

20ms 40ms T

10ms

# FIG. 6

# FIG. 7

# FIG. 8

VACUUM CIRCUIT BREAKER

8

# FIG. 9

VACUUM SWITCH GEAR

# FIG. 10

30

36

VACUUM SWITCH GEAR

21a

20